# EUROPEAN PATENT APPLICATION

(11) **EP 4 823 291 A1**
(43) Date of publication of application: **14.10.2026**
(21) Application number: 25211385.7
(22) Date of filing: 27.10.2025
(51) Int. Cl.: H10H 29/14, H01S 5/183, H10H 29/24, H10H 29/39, H10H 29/49

(54) **WIRING STRUCTURE AND LIGHT EMITTING DEVICE**

(30) Priority: 08.04.2025 JP 2025063697
(71) Applicant: FUJIFILM Business Innovation Corp., Minato-ku Tokyo (JP)
(72) Inventor: HIGUCHI, Takafumi, Ebina-shi, Kanagawa (JP); ONO, Seiji, Ebina-shi, Kanagawa (JP); MINAMIRU, Takeshi, Ebina-shi, Kanagawa (JP)
(74) Representative: Becker Kurig & Partner Patentanwälte mbB

(57) **Abstract**

A wiring structure includes: plural light emitting units that each include a thyristor structure and emit light at timings different from each other as signals are supplied to thyristors; and a wiring unit that connects electrodes, which supply a common current to the plural light emitting units, and the plural light emitting units to supply a current, and covers a region, which excludes at least a part of portions between emission portions through which light is emitted from the plural light emitting units and the plural light emitting units, while connecting the plural light emitting units emitting light at the different timings.

## Description

### BACKGROUND OF THE INVENTION

### (i) Field of the Invention

The technology of the present disclosure relates to a wiring structure and a light emitting device.

### (ii) Description of Related Art

JP2023-145073A discloses a light emitting element. The light emitting element includes: a light emitting unit in which a plurality of semiconductor layers are laminated, and in plan view, a length between a center of the light emitting unit and an end portion in a first direction is shorter than a length between the center and an end portion in a second direction intersecting the first direction; and a connection portion that extends from the light emitting unit in the first direction and connects the light emitting unit to another semiconductor layer.

### SUMMARY OF THE INVENTION

A solid wiring method is adopted in which wiring is performed to cover all mesas (semiconductor islands) except for a light emitting region is employed in a VCSEL device disclosed in JP2023-145073A. However, in the solid wiring method, parasitic capacitance is increased, and particularly, the falling time of a pulse waveform is lengthened. In a case where the coverage is simply reduced to improve the parasitic capacitance and the falling time, wiring resistance increases, which causes a risk that the light emitting element is unintentionally turned on.

An object of the present disclosure is to provide a wiring structure and a light emitting device in which parasitic capacitance can be reduced while an increase in wiring resistance is suppressed.

According to a first aspect of the present disclosure, there is provided a wiring structure including: a plurality of light emitting units that each include a thyristor structure and emit light at timings different from each other as signals are supplied to thyristors; and a wiring unit that connects electrodes, which supply a common current to the plurality of light emitting units, and the plurality of light emitting units to supply a current, and covers a region, which excludes at least a part of portions between emission portions through which light is emitted from the plurality of light emitting units and the plurality of light emitting units, while connecting the plurality of light emitting units emitting light at the different timings.

According to a second aspect of the present disclosure, the wiring structure may further include: one or more bridges that connect adjacent mesas forming the light emitting units and extend in a first direction; and a plurality of divided regions that are arranged to be spaced apart from each other in a second direction intersecting the first direction while extending in the first direction. The wiring unit may include one or more first wirings that are arranged to be spaced apart from each other in the first direction while each extending in the second direction across the plurality of divided regions.

According to a third aspect of the present disclosure, in the wiring structure, the first wirings may be provided on the bridges.

According to a fourth aspect of the present disclosure, in the wiring structure, the first wirings may be provided across some of the plurality of bridges.

According to a fifth aspect of the present disclosure, in the wiring structure, the mesas adjacent to each other in the second direction may be arranged to be offset from each other in the first direction, and the first wirings may be formed in a meandering shape or a zigzag shape in plan view.

According to a sixth aspect of the present disclosure, the wiring structure may further include: one or more bridges that connect adjacent mesas forming the light emitting units and extend in a first direction; and a plurality of divided regions that are arranged to be spaced apart from each other in a second direction intersecting the first direction while extending in the first direction. The wiring unit may include one or more second wirings that are arranged to be spaced apart from each other in the second direction while each covering a part of the mesas and extending in the first direction.

According to a seventh aspect of the present disclosure, in the wiring structure, the second wirings may not cross the plurality of divided regions.

According to an eighth aspect of the present disclosure, in the wiring structure, the second wirings adjacent to each other in the second direction among the plurality of second wirings may be connected to each other at one or a plurality of positions in the first direction.

According to a ninth aspect of the present disclosure, in the wiring structure, the wiring unit may cover a region between a plurality of electrodes arranged to be spaced apart from each other with the plurality of light emitting units interposed therebetween while connecting the plurality of electrodes.

According to a tenth aspect of the present disclosure, in the wiring structure, each of the light emitting units may consist of a thyristor having a PNPN junction and a vertical-cavity surface-emitting laser having a PN junction different from the junction of the thyristor, and the thyristor may be formed on a wiring side, and may further include a dielectric that is provided between the wiring unit and a semiconductor layer included in the thyristor structure and is made of a low-dielectric-constant material.

According to an eleventh aspect of the present disclosure, in the wiring structure, the second wirings adjacent to each other in the second direction among the plurality of second wirings may surround peripheries of the emission portions and shield the divided regions from the emission portions while extending in the first direction.

According to a twelfth aspect of the present disclosure, the wiring structure may further include a photosensitive light absorbing member that is provided in each of the divided regions.

According to a thirteenth aspect of the present disclosure, there is provided a light emitting device including: the wiring structure according to any one of the first to twelfth aspects; and the plurality of electrodes.

According to the first aspect of the present disclosure, since the wirings are provided only in the region A excluding a part of portions between the emission portions and the light emitting units, it is possible to reduce parasitic capacitance due to the wirings around the light emitting units while suppressing an increase in wiring resistance. For this reason, the falling time of a pulse waveform of a VCSEL device due to the parasitic capacitance is shortened, so that the risk of erroneous lighting can be reduced.

According to the second aspect of the present disclosure, it is possible to uniformly supply a current.

According to the third aspect of the present disclosure, it is possible to achieve the uniformity of current supply.

According to the fourth aspect of the present disclosure, it is possible to further suppress an increase in parasitic capacitance.

According to the fifth aspect of the present disclosure, since the mesas are offset from each other in the first direction and the second direction, it is possible to achieve a reduction in size and to suppress an increase in parasitic capacitance.

According to the sixth aspect of the present disclosure, it is possible to reduce parasitic capacitance while suppressing the influence of the light emission of the other light emitting unit groups and the external light.

According to the seventh aspect of the present disclosure, since wiring does not have to be performed on a portion where there is a difference in height, that is, a portion corresponding to a high mesa and a portion corresponding to a low divided region, it is difficult to form a film in a case where there is a difference in height, but it is easy to perform wiring on a portion where there is no difference in height.

According to the eighth aspect of the present disclosure, the uniformity of current supply is improved.

According to the ninth aspect of the present disclosure, the current is more stable than in a case where one electrode is provided.

According to the tenth aspect of the present disclosure, parasitic capacitance is reduced as compared with a case where the dielectric is provided without focusing on a dielectric constant.

According to the eleventh aspect of the present disclosure, it is possible to suppress unnecessary electromagnetic interference as compared with a configuration in which all the emission portions are not surrounded.

According to the twelfth aspect of the present disclosure, since the photosensitive light absorbing member is provided in the divided region, it is possible to reduce the influence of external light to prevent the malfunction of the light emitting unit.

According to the thirteenth aspect of the present disclosure, the falling time of the VCSEL of the light emitting device is shortened and a short-pulse response is enabled.

### BRIEF DESCRIPTION OF THE DRAWINGS

Exemplary embodiment(s) of the present invention will be described in detail based on the following figures, wherein:
FIG. 1 is a diagram showing a configuration example of a wiring structure 100A according to an exemplary embodiment of the present disclosure;
FIG. 2 is a diagram showing a configuration example of a light emitting device 200 including a wiring structure 100A according to the exemplary embodiment of the present disclosure;
FIG. 3 is a diagram showing a configuration example of a wiring structure 100B according to the exemplary embodiment of the present disclosure;
FIG. 4 is a diagram showing a configuration example of a light emitting device 200 including the wiring structure 100B according to the exemplary embodiment of the present disclosure;
FIG. 5 is a cross-sectional view taken along line X-X shown by a dash-dotted line in FIG. 1;
FIG. 6 is a diagram illustrating a current distribution in the light emitting device 200 including the wiring structure 100B;
FIG. 7 is a diagram showing a relationship between the number and arrangement of transverse wirings of the wiring structure 100B and the influence of the number and arrangement on current unevenness;
FIG. 8 is a diagram in which the wiring resistances of second wirings and the transverse wirings of the wiring structure 100B and current unevenness are compared;
FIG. 9 is a diagram in which the wiring resistances of the second wirings and the transverse wirings of the wiring structure 100B and current unevenness are compared;
FIG. 10 is a diagram in which the wiring resistances of the second wirings and the transverse wirings of the wiring structure 100B and current unevenness are compared;
FIG. 11 is a diagram showing a configuration example of a light emitting device 200C including a wiring structure 100C according to a comparative example;
FIG. 12 is a diagram illustrating the influence of tailing in a waveform of a light pulse output from the light emitting device 200C according to the comparative example;
FIG. 13 is a diagram showing an example in which two transverse wirings are combined with the second wirings;
FIG. 14 is a diagram showing an example in which five first wirings are combined with the second wirings;
FIG. 15 is a diagram showing an example of a wiring structure 100A including the five first wirings shown in FIG. 14;
FIG. 16 is a diagram showing an example in which three transverse wirings are combined with the second wirings;
FIG. 17 is a diagram illustrating a configuration that suppresses the influence of a capacitance component in the wiring structure 100B;
FIG. 18 is a diagram illustrating the configuration that suppresses the influence of the capacitance component in the wiring structure 100B;
FIG. 19 is a diagram illustrating the configuration that suppresses the influence of the capacitance component;
FIG. 20 is a diagram illustrating a capacitance component generated in the wiring structure 100C according to the comparative example;
FIG. 21 is a diagram illustrating the capacitance component generated in the wiring structure 100C according to the comparative example;
FIG. 22 is a diagram illustrating a configuration that suppresses the influence of a capacitance component in the wiring structure 100A;
FIG. 23 is a diagram illustrating the configuration that suppresses the influence of the capacitance component in the wiring structure 100A;
FIG. 24 is a diagram illustrating the configuration that suppresses the influence of the capacitance component in the wiring structure 100A;
FIG. 25 is a diagram illustrating the configuration that suppresses the influence of the capacitance component in the wiring structure 100A;
FIG. 26 is a diagram illustrating the configuration that suppresses the influence of the capacitance component in the wiring structure 100A;
FIG. 27 is a diagram illustrating the configuration that suppresses the influence of the capacitance component in the wiring structure 100A;
FIG. 28 is a diagram illustrating a difference in parasitic capacitance depending on the wiring structure;
FIG. 29 is a diagram illustrating a current distribution and resistance characteristics depending on differences in the wiring structures;
FIG. 30 is a diagram illustrating a current distribution and resistance characteristics depending on differences in the wiring structures;
FIG. 31 is a diagram illustrating a current distribution and resistance characteristics depending on differences in the wiring structures;
FIG. 32 is a diagram illustrating a current distribution and resistance characteristics depending on differences in the wiring structures;
FIG. 33 is a diagram illustrating the occurrence of erroneous lighting (unintended light emission) due to a difference in wiring structure and a method of suppressing the occurrence of erroneous lighting;
FIG. 34 is a diagram illustrating the occurrence of erroneous lighting (unintended light emission) due to a difference in wiring structure and a method of suppressing the occurrence of erroneous lighting;
FIG. 35 is a diagram illustrating the occurrence of erroneous lighting (unintended light emission) due to a difference in wiring structure and a method of suppressing the occurrence of erroneous lighting;
FIG. 36 is a diagram illustrating the occurrence of erroneous lighting (unintended light emission) due to a difference in wiring structure and a method of suppressing the occurrence of erroneous lighting; and
FIG. 37 is a diagram illustrating the occurrence of erroneous lighting (unintended light emission) due to a difference in wiring structure and a method of suppressing the occurrence of erroneous lighting.

### DETAILED DESCRIPTION OF THE INVENTION

An example of an exemplary embodiment of the technology of the present disclosure will be described below with reference to the drawings. In the respective drawings, identical or equivalent components and portions will be denoted by identical reference numerals. Further, since the scales of the drawings are exaggerated for convenience of description, the scales may be different from actual scales.

### (Exemplary Embodiment)

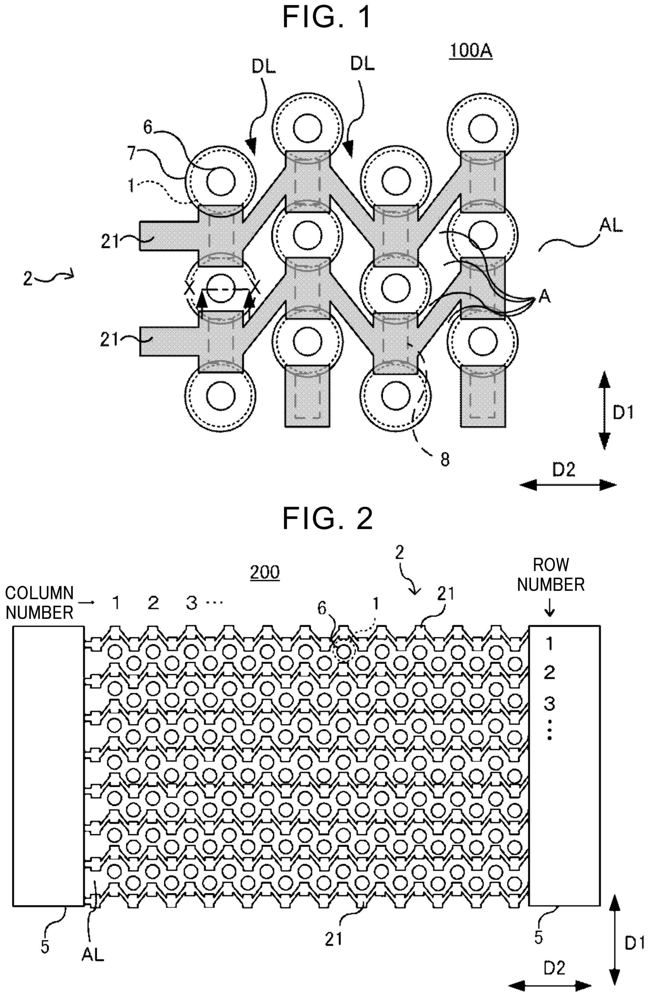

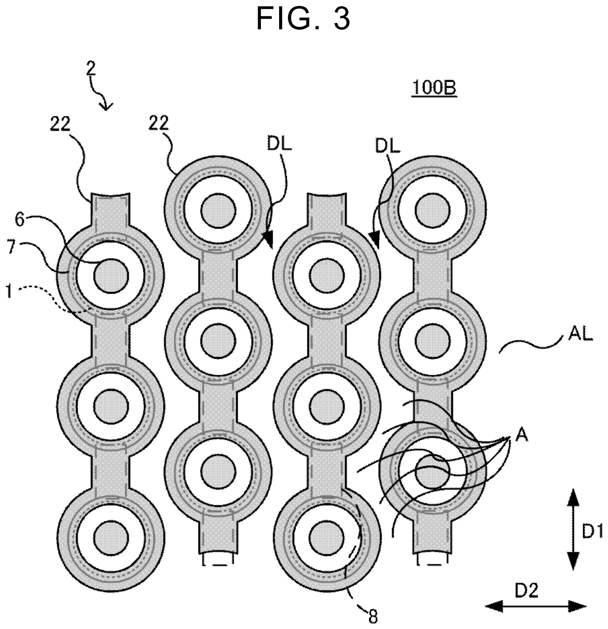

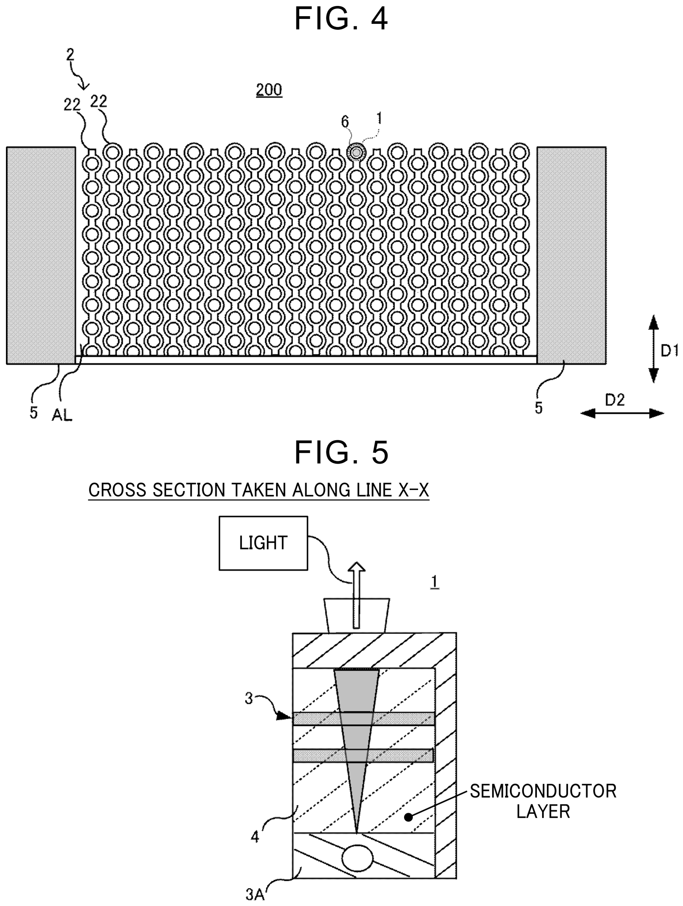

FIGS. 1 and 2 show a wiring structure 100A included in a light emitting device 200 according to a first aspect of an exemplary embodiment of the present disclosure. FIGS. 3 and 4 show a wiring structure 100B included in a light emitting device 200 according to a second aspect of the exemplary embodiment of the present disclosure. The light emitting device 200 according to the first aspect will be described first, and then the light emitting device 200 according to the second aspect will be described. FIG. 5 is a cross-sectional view taken along the line X-X shown by a dash-dotted line in FIG. 1.

As shown in FIG. 1, the wiring structure 100A includes a plurality of light emitting units 1 and a wiring unit 2. The light emitting unit 1 includes a thyristor structure shown in FIG. 5. The light emitting units 1 emit light at timings different from each other as signals are supplied to thyristors 3. Specifically, the light emitting unit 1 includes, for example, a thyristor 3 having a PNPN junction and a vertical-cavity surface-emitting laser (VCSEL 3A) having a junction structure (for example, a PN junction) different from the junction of the thyristor 3. In FIG. 5, for example, the thyristor 3 is formed above the VCSEL 3A, that is, on the side of the wiring unit 2 shown in FIG. 1, and further includes a dielectric that is provided between the wiring unit 2 and a semiconductor layer 4 included in the thyristor structure and is made of a low-dielectric-constant material. The low-dielectric-constant material is a material that is used to reduce parasitic capacitance and to enable high-speed operation in a semiconductor device or a high-frequency circuit, and examples thereof include a siloxane-based polymer, porous silica, a fluorine-doped silicon oxide film, and benzocyclobutene.

The semiconductor layer 4 is a region in which the light emitting unit 1 is disposed, and light is emitted in a case where a current flows through the semiconductor layer 4.

The configuration of the light emitting unit 1 is not limited thereto, and the thyristor 3 may be disposed below the VCSEL 3A.

The VCSEL 3A may be interpreted as a light emitting layer that emits light. As shown in FIGS. 1 and 2, the wiring unit 2 is a metal wiring that connects electrodes 5, which supply a common current to the plurality of light emitting units 1, and the plurality of light emitting units 1 to supply a current. The wiring unit 2 covers regions A, which exclude at least a part of portions between emission portions 6 through which light is emitted from the plurality of light emitting units 1 and the plurality of light emitting units 1, while connecting the plurality of light emitting units 1 that emit light at different timings. The wiring unit 2 covers a region AL between the plurality of electrodes 5 while connecting the plurality of electrodes 5 arranged to be spaced apart from each other with the plurality of light emitting units 1 interposed therebetween. A current is supplied to the entire VCSEL array from the electrodes 5 disposed at both ends. The VCSEL array is a light emitting unit group that is formed in a case where the plurality of light emitting units 1 are arranged in a first direction D1 and a second direction D2.

As shown in FIG. 1, the wiring structure 100A includes one or more bridges 8 that connect adjacent mesas 7 forming the light emitting units 1 and extend in the first direction D1, and a plurality of divided regions DL that are arranged to be spaced apart from each other in the second direction D2 intersecting the first direction D1 while extending in the first direction D1. The wiring unit 2 includes one or more first wirings 21 that are arranged to be spaced apart from each other in the first direction D1 while each extending in the second direction D2 across the plurality of divided regions DL. The mesa 7 is formed around the VCSEL 3A.

The first wirings 21 are provided on the bridges 8, and specifically, are provided across some of the plurality of bridges 8. Some of the bridges 8 are at least a plurality of bridges 8 present at different positions in the second direction D2, and the first wiring 21 is provided across some of the bridges 8 to connect the plurality of bridges 8. More specifically, the mesas 7 adjacent to each other in the second direction D2 are arranged to be offset from each other in the first direction D1, and the first wirings 21 are formed in a meandering shape or a zigzag shape in plan view. The meandering shape is a pattern that meanders in an S-shape. The zigzag shape is a linear pattern that is sharply folded. More specifically, the meandering shape refers to a wiring shape that extends while being smoothly bent in an S-shape in plan view. In the present disclosure, the first wiring 21 having a meandering shape is bent in a form of a continuous curve or at a gentle angle. In a case where the first wiring 21 is formed in a meandering shape, the wiring length of the first wiring 21 can be shortened through curved connections. As the wiring length is shortened, a resistance value is reduced. As a result, the concentration of a current on a specific light emitting unit 1 can be prevented. The zigzag shape refers to a wiring shape that linearly extends while being sharply folded in plan view. In the present disclosure, the first wiring 21 having a zigzag shape forms a pattern composed of straight lines and a folded portion having an acute angle. In a case where the first wiring 21 is formed in a zigzag shape, the first wiring 21 is structurally formed by repetition of a straight line and a folded point. Accordingly, a design can be simplified, so that development cost and manufacturing cost can be reduced. Since the first wiring 21 is formed by repetition of a straight line and a folded point, the first wiring 21 is easily stored in a limited region as compared with a wiring having a curvature. As a result, the space efficiency of the first wiring 21 is improved.

FIGS. 3 and 4 show the wiring structure 100B included in the light emitting device 200 according to the second aspect of the exemplary embodiment of the present disclosure. The wiring structure 100B includes a plurality of light emitting units 1 that are identical to the light emitting units 1 of the wiring structure 100A described above. In the wiring structure 100B, the shape of a wiring unit 2 is different from the shape of the wiring unit 2 of the wiring structure 100A.

The wiring unit 2 of the wiring structure 100B is a metal wiring that connects electrodes 5, which supply a common current to the plurality of light emitting units 1, and the plurality of light emitting units 1 to supply a current, as with the wiring unit 2 of the wiring structure 100A. The wiring unit 2 of the wiring structure 100B covers regions A, which exclude at least a part of portions between emission portions 6 through which light is emitted from the plurality of light emitting units 1 and the plurality of light emitting units 1, while connecting the plurality of light emitting units 1 that emit light at different timings. Further, the wiring unit 2 covers a region AL between the plurality of electrodes 5 while connecting the plurality of electrodes 5 arranged to be spaced apart from each other with the plurality of light emitting units 1 interposed therebetween, as with the wiring unit 2 of the wiring structure 100A.

The wiring structure 100B includes one or more bridges 8 that connect adjacent mesas 7 forming the light emitting units 1 and extend in the first direction D1, and a plurality of divided regions DL that are arranged to be spaced apart from each other in the second direction D2 intersecting the first direction D1 while extending in the first direction D1.

The wiring unit 2 includes one or more second wirings 22 that are arranged to be spaced apart from each other in the second direction D2 while each covering a part of the mesas 7 and extending in the first direction D1. The second wirings 22 do not cross the plurality of divided regions DL. Further, the second wirings 22 adjacent to each other in the second direction D2 among the plurality of second wirings 22 are connected to each other at one or a plurality of positions in the first direction D1. For example, as shown in FIG. 4, the second wirings 22 are connected to each other by a wiring that connects the electrodes 5 and is provided at a lower end in FIG. 4.

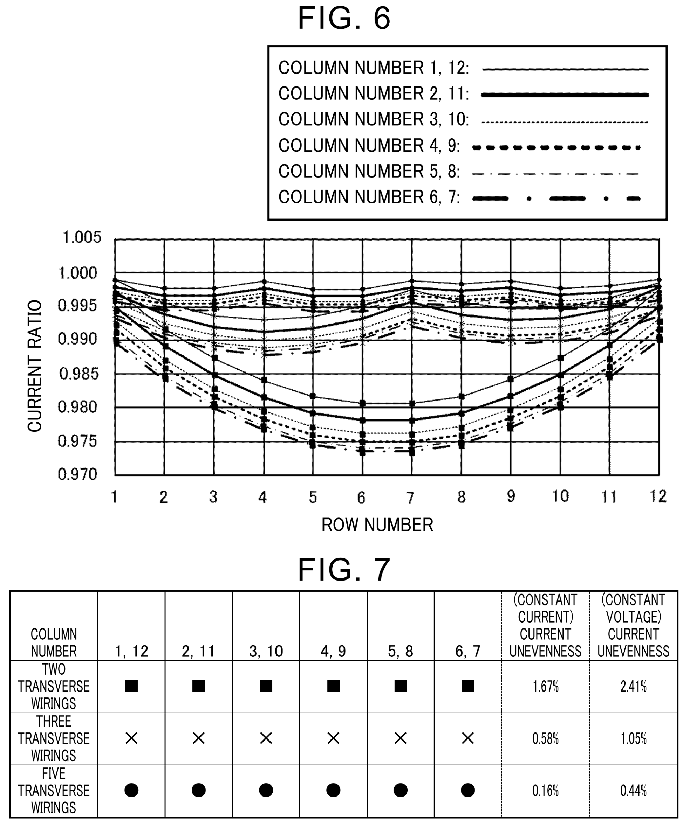

FIGS. 6 and 7 show analysis results of the influence of the first wirings 21 on the wiring structure of the VCSEL array, and particularly the influence on the uniformity of a current distribution and light emission unevenness (light amount unevenness).

In FIG. 6, a vertical axis represents a current ratio. The current ratio represents a current ratio of each light emitting unit 1, and is based on 1.0 as a value relative to a current value obtained in a case where wiring resistance is zero (ideal state). The closer the value is to 1.0, the more ideal the current supply is. A value less than 1.0 indicates that the current supply is insufficient (the light emission is weak), and conversely, a value greater than 1.0 indicates that a current is concentrated (the light emission is intense).

Each light emitting unit 1 is assigned with a row number and a column number. For example, in FIG. 2, the plurality of light emitting units 1 are positioned between the first wirings 21. Here, for example, the light emitting units 1 arranged in the first direction D1 in order from the top are assigned row numbers "1", "2", "3", ..., and the light emitting units 1 arranged in the second direction D2 in order from the left are assigned column numbers in ascending order. In FIG. 2, the light emitting units 1 are arranged to be slightly offset from each other in a vertical direction as viewed in the second direction D2. However, in any column, the first light emitting unit 1 from the top is assigned a row number "1", and the second light emitting unit 1 is assigned a row number "2". Accordingly, for example, the light emitting units 1 assigned a row number "1" are arranged while being offset from each other in the vertical direction as viewed in the second direction D2.

In FIG. 6, the current ratio of each light emitting unit 1 is shown for a device including 144 light emitting units 1 assigned row numbers "1" to "12" and column numbers "1" to "12". Two columns having an identical distance from the electrodes, such as column numbers "1" and "12" or column numbers "2" and "11", are represented as one set. The reason for this is that the current ratio varies depending on the distance from the electrode. Further, in FIG. 7, the current ratios of the light emitting units 1 in each column in a case where the number of first wirings 21 disposed in the device is two (two transverse wirings) are represented by black squares. The current ratios of the light emitting units 1 in each column in a case where the number of first wirings 21 is three (three transverse wirings) are represented by X (cross). The current ratios of the light emitting units 1 in each column in a case where the number of first wirings 21 is four are represented by black circles.

As described above, the current ratios of the light emitting units 1 in each row and each column in a case where the number of first wirings 21 varies are as shown in FIG. 6. Hereinafter, a graph will be described in detail.

Even in a case where the number of first wirings is 2, 3, or 5, the current ratios of the light emitting units 1 assigned column numbers "1" and "12" are the highest, and the current ratios of the light emitting units 1 assigned column numbers "6" and "7" are the lowest. Accordingly, it can be seen that the current supply is more affected and the degree of decrease in the current ratio is higher as the distance between the light emitting unit 1 and the electrode 5 increases, and the current ratio tends to decrease for a light emitting unit positioned in a column closer to the middle. The current ratio is higher in a case where the number of first wirings 21 is three than in a case where the number of first wirings 21 is two. The current ratio is higher in a case where the number of first wirings 21 is five than in a case where the number of first wirings 21 is three. The following points will be examined below for each number of first wirings 21.

### (1) Case of two transverse wirings

In a case where the number of first wirings 21 is two, the current ratio decreases in a middle portion of the graph (sixth and seventh rows) and reaches a maximum at both end portions of the graph (first and twelfth rows). That is, it can be seen that the distribution of the current ratio is in a "bowl shape" and the light emission intensity of the light emitting units 1 assigned intermediate row numbers is reduced. The reason for this is that the two first wirings 21 are disposed to correspond to the positions of the light emitting units 1 assigned row numbers "1" and "12". In a case where two first wirings 21 are disposed as described above, a current is concentrated at both ends. Accordingly, it is considered that the supply of a current to light emitting points in the middle of the graph is insufficient.

### (2) Case of three transverse wirings

One first wiring 21 is added, and the third first wiring 21 is disposed to correspond to the position of the light emitting unit 1 assigned a row number "7". In this case, a current corresponding to the seventh row increases and is adjusted to a level identical to the level of the first and twelfth rows. As a result, a distribution is "double valley type", and a current in the middle of the graph is equalized.

### (3) Case of five transverse wirings

Further, two first wirings 21 are added, and the fourth and fifth first wirings are disposed to correspond to the positions of the light emitting units 1 assigned row numbers "4" and "9", respectively. In this case, a current distribution is further uniform, and four valleys (four valley distribution) are formed. The depths of the valleys become shallow, and the supply of a current to the middle portion is stabilized.

As described above, the current ratios increase as the number of first wirings 21 increases. However, it can be seen that, in a case where at least three first wirings 21 are provided, only two low valleys are obtained and the average value of the current ratios is considerably increased as compared with the case of two first wirings 21.

FIG. 7 also shows how much the increase in the number of transverse wirings improves light emission unevenness (light amount unevenness).

### (1) Case of constant-current driving

The current value for each light emitting point is adjusted, and the maximum and minimum current values of the columns that are simultaneously turned on are compared. In a case where five transverse wirings are applied, current unevenness is reduced to 1/10 as compared with a case where two transverse wirings are applied. The current supply is made uniform, so that a variation in light emission intensity is reduced.

### (2) Case of constant-voltage driving

For example, in a case where a minimum/maximum ratio of a current is calculated and light amount unevenness is evaluated for each of 144 light emitting points, the "minimum/maximum - 1" of the current at the 144 light emitting points is obtained under a constant voltage. It can be seen that the increase in the number of transverse wirings reduces a variation in current and improves light emission uniformity. The "minimum/maximum - 1" is an index for evaluating the current unevenness of the entire VCSEL array. Since an identical voltage is applied to all the light emitting points in constant-voltage driving, a variation in the current value occurs due to the influence of wiring resistance or parasitic capacitance. The minimum/maximum ratio is used to quantitatively measure this variation. For example, in a case where the maximum current value Imax is 10 mA and the minimum current value Imin is 9.5 mA, Imin/Imax is 0.95. Therefore, the current unevenness is -0.05 (= 0.95 - 1) (-5%). The more negative this value is, the smaller current unevenness is.

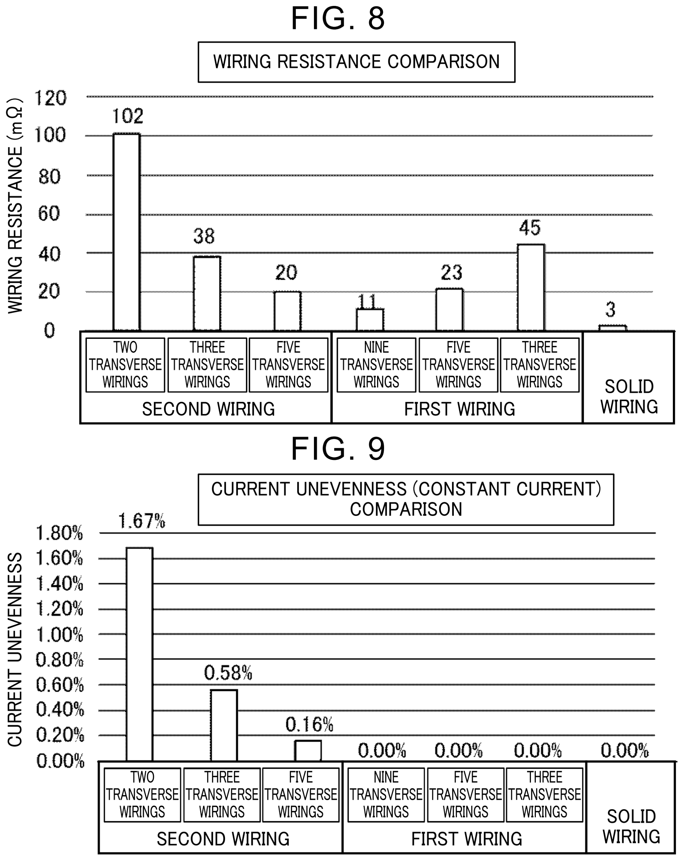

FIGS. 8, 9, and 10 show wiring resistance, wiring unevenness, and the like in different wiring methods (wiring structures).

A vertical axis in FIG. 8 represents the wiring resistance, and a horizontal axis in FIG. 8 represents different types of wiring methods, specifically, the first wirings 21 and the second wirings 22 of the present disclosure, a solid wiring of a comparative example to be described later, and the like.

As can be seen from this graph, the wiring resistance in the case of "two transverse wirings (second wirings 22)" is the highest at 102 mΩ. Since the number of transverse wirings is small, a path through which a current flows is limited. As a result, the resistance is increased. In a case where the number of transverse wirings is increased, the wiring resistance tends to be reduced. For example, the wiring resistance is 20 mΩ in the case of five transverse wirings (second wirings 22), and the wiring resistance is reduced to 11 mΩ in the case of nine transverse wirings (first wirings 21). The solid wiring has the lowest resistance of 3 mΩ, but has a disadvantage of an increase in parasitic capacitance.

In FIG. 9, a vertical axis represents current unevenness under a constant current and a horizontal axis represents different types of wiring methods. According to FIG. 9, the current unevenness is the largest at 1.67% in the case of two transverse wirings (second wirings 22). Since the number of transverse wirings is small, a bias occurs in the current distribution at the middle and the end portions. The current unevenness is reduced to 0.58% in the case of three transverse wirings (second wirings 22) and to 0.16% in the case of five transverse wirings (second wirings 22). The current unevenness is 0.00% in the cases of nine transverse wirings (first wirings 21), five transverse wirings (first wirings 21), three transverse wirings (first wirings 21), and the solid wiring. In a case where transverse wirings are sufficiently provided, a current is uniformly distributed.

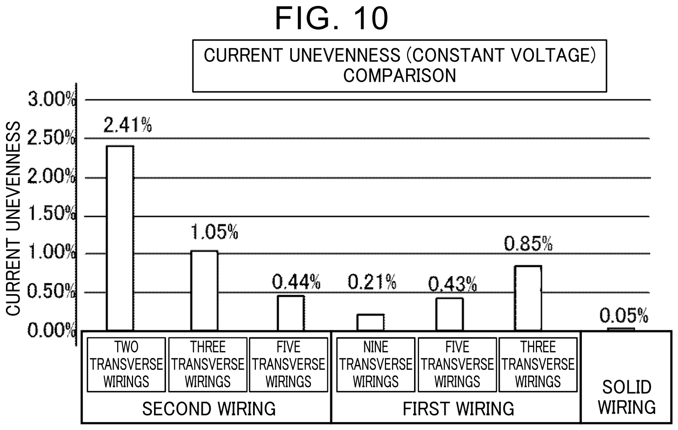

In FIG. 10, a vertical axis represents current unevenness under a constant voltage and a horizontal axis represents different types of wiring methods. According to FIG. 10, the current unevenness is the largest at 2.41% in the case of two transverse wirings (second wirings 22). Since constant-voltage driving is likely to be affected by wiring resistance, a bias in the current distribution increases. The current unevenness is reduced to 1.05% in the case of three transverse wirings (second wirings 22) and to 0.44% in the case of five transverse wirings (second wirings 22). The current unevenness is suppressed to 0.21% in the case of nine transverse wirings (first wirings 21), and is the smallest. In the case of the solid wiring, the current unevenness has the lowest value of 0.05% but there is a problem with parasitic capacitance.

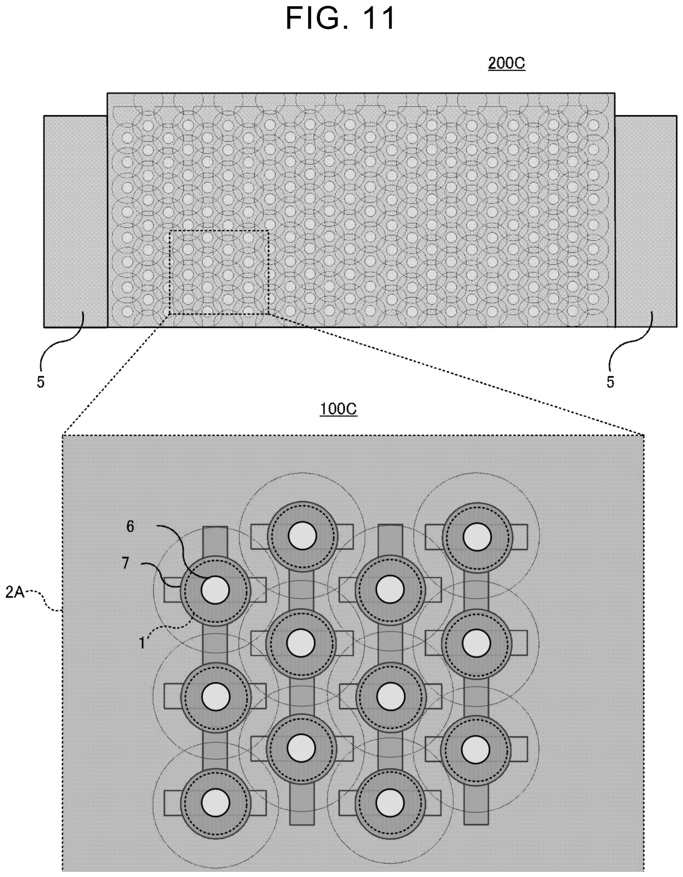

FIG. 11 shows a configuration example of a light emitting device 200 including a wiring structure 100C according to a comparative example, which includes a solid wiring (wiring unit 2A). An overall view of the light emitting device 200 of the comparative example is shown on the upper side in FIG. 11, and a current is supplied from the right and left electrodes 5. An enlarged detailed view of a part of the light emitting device 200 is shown on the lower side in FIG. 11. The wiring unit 2A is a wide-area wiring that is designed to cover all the plurality of light emitting units 1, and covers all the regions A excluding the respective emission portions 6. That is, the wiring is disposed to cover the entire periphery of the light emitting layer. Since the wiring continuously spreads over a wide range, parasitic capacitance is likely to increase.

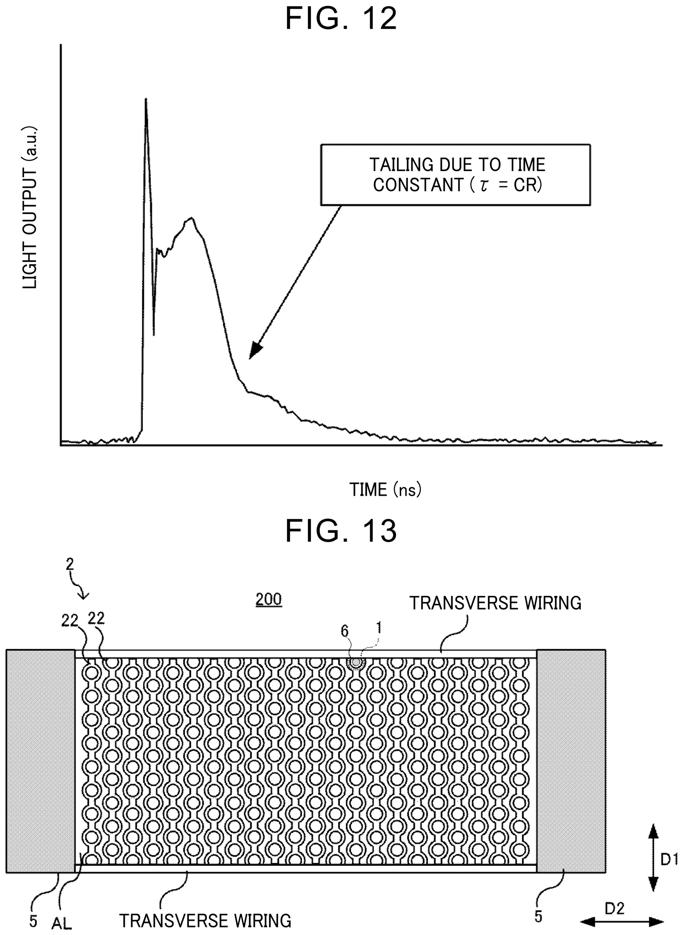

Since the parasitic capacitance is large, the high-speed responsiveness of the VCSEL 3A is degraded due to the influence of so-called "tailing" in which the falling time of a light pulse waveform increases as shown in FIG. 12. FIG. 12 shows the relative light intensity (light output) of a light pulse emitted from the light emitting device 200 of the comparative example, and a vertical axis in FIG. 12 represents the light output and a horizontal axis in FIG. 12 represents time. As shown in FIG. 12, it can be confirmed that the light output gradually attenuates after a peak. Although the light output drops sharply immediately after the peak, the subsequent attenuation continues for a long time. Accordingly, ideal short-pulse light emission does not occur. This is considered to be due to the influence of a time constant of a circuit (τ = CR: a product of resistance R and capacitance C). For example, in a case where a short pulse is to be realized, a waveform having a sharp rise and a short fall (attenuation) is desirable. Since the risk of interference with the next pulse and the risk of erroneous lighting during a high-speed operation increase in a case where the tailing is considerable, improvement is necessary.

On the other hand, since the wirings are provided only in the regions A excluding a part of portions between the emission portions and the light emitting units in the present disclosure, it is possible to reduce parasitic capacitance due to the wirings around the light emitting units while suppressing an increase in wiring resistance. For this reason, the falling time of a pulse waveform of a VCSEL device due to the parasitic capacitance is shortened, so that the risk of erroneous lighting can be reduced. Since the falling time of the pulse waveform is shortened, a high-speed response of the pulse of the VCSEL can be achieved. Further, since a current supply path to each light emitting unit is efficiently configured by a configuration in which a wiring is individually drawn to each light emitting unit and common electrodes are combined, a bias in current supply is eliminated, the light emission unevenness of the entire VCSEL array is reduced, and wiring resistance is dispersed. As a result, overheating and loss are also suppressed. Since a wiring area can be efficiently used due to the wiring configuration excluding portions between the emission portions and the light emitting units, the miniaturization of the device can also be achieved.

FIG. 13 shows an example in which two transverse wirings are combined with the second wirings 22 of the wiring structure 100B as an example of wiring optimization for realizing uniform light emission characteristics of the VCSEL 3A. In the VCSEL array, two transverse wirings are provided to extend in the second direction D2. A current is supplied via the transverse wirings (first wirings 21) and the second wirings 22.

Since the wiring structure shown in FIG. 13 is provided with two transverse wirings, a current supply path is limited. As a result, wiring resistance becomes relatively high. Further, since the number of transverse wirings is small, the flow of a current is likely to be biased at the middle and the end portions. In a case where the number of transverse wirings is increased, a current can be more uniformly supplied.

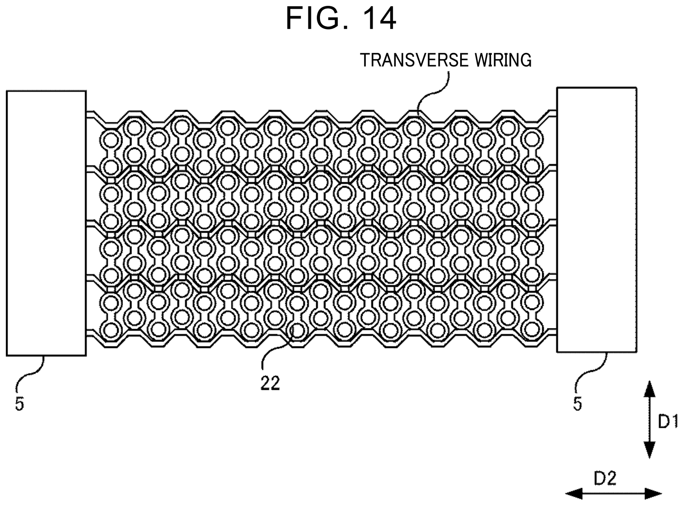

FIG. 14 shows an example in which five transverse wirings are combined with the second wirings 22 of the wiring structure 100B. In the VCSEL array, five transverse wirings are provided to extend in the second direction D2. The five transverse wirings are arranged at regular intervals in the first direction D1. In a case where the number of transverse wirings is increased, the number of current supply paths increases and thus wiring resistance is further reduced. Accordingly, the bias of a current (current unevenness) is reduced and the uniformity of light emission is improved. Since a current is more uniformly distributed, the light emission unevenness of the entire VCSEL array can be suppressed.

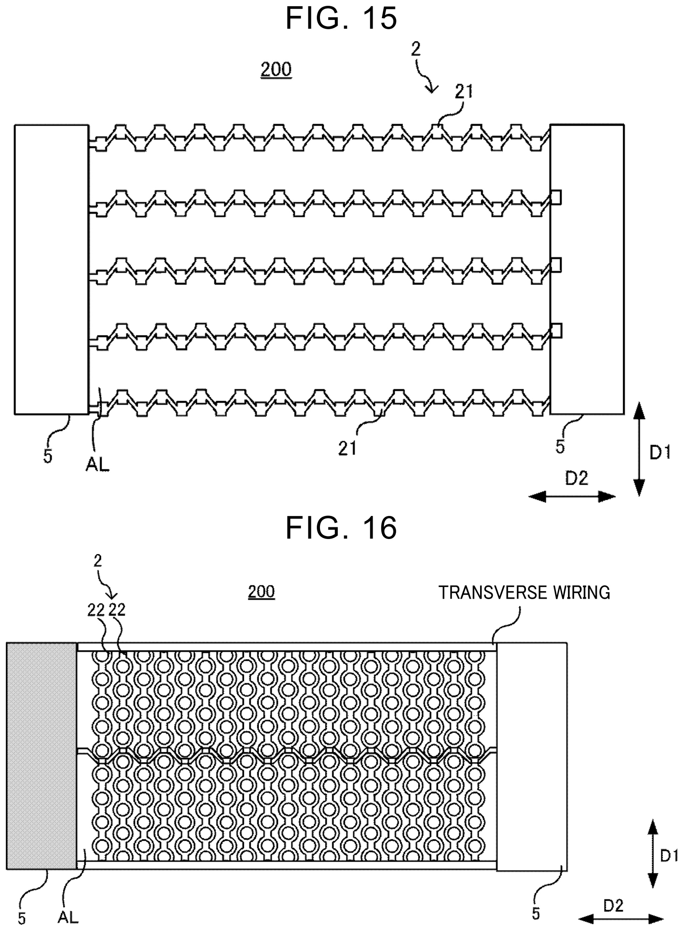

FIG. 15 shows a configuration example of the wiring structure 100A including five first wirings 21. Since each of the first wirings 21 has a wavy shape (a meandering shape or a zigzag shape), it is possible to uniformly supply a current while shortening the total wiring length. Further, it is possible to prevent a current from being concentrated on the specific light emitting unit 1 and to reduce overall current unevenness, as compared with linear wirings. Furthermore, since the five first wirings 21 are uniformly arranged as the transverse wirings, a current can be uniformly supplied and thus it is expected that light emission unevenness is reduced. Since a wavy wiring structure is used, it is possible to balance the current supply while suppressing an increase in wiring length. This configuration example contributes to improving the efficiency of current supply and reducing light emission unevenness in the VCSEL array where a high-speed operation is required.

In the wiring structure 100A including the five first wirings 21 as shown in FIG. 2 described above, the supply of a current to the light emitting units 1 is more uniform and the bias of a current is suppressed. As the number of wirings increases, a current flowing through each wiring is dispersed, that is, the resistance load of each wiring is dispersed. Therefore, it is possible to suppress a voltage drop due to the resistance of the wirings while suppressing an increase in parasitic capacitance. Accordingly, the uniformity of the supply of a current to the light emitting unit 1 is improved, so that light emission unevenness is further suppressed.

FIG. 16 shows an example in which three transverse wirings are combined with the second wirings 22 of the wiring structure 100B. Among the three transverse wirings, one middle transverse wiring is provided in a middle portion between upper and lower wirings in the first direction D1. Accordingly, as compared with the case of two transverse wirings as shown in FIG. 13, a bias in the path through which a current flows is less likely to occur, that is, the supply of a current to the middle portion in the first direction D1 is improved. Accordingly, a variation in light emission intensity can be suppressed. Further, in a case where three transverse wirings are provided, the supply of a current to the middle portion is assisted and the current is uniformly distributed. Therefore, the brightness unevenness of the light emitting points is reduced, so that more stable light output is obtained. Furthermore, since a current path is shortened as compared with the case of two transverse wirings as shown in FIG. 13, wiring resistance can be reduced.

### (Details of parasitic capacitance)

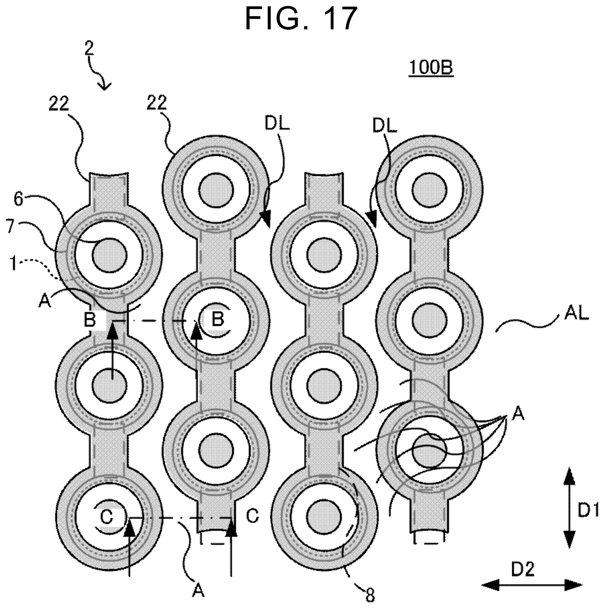

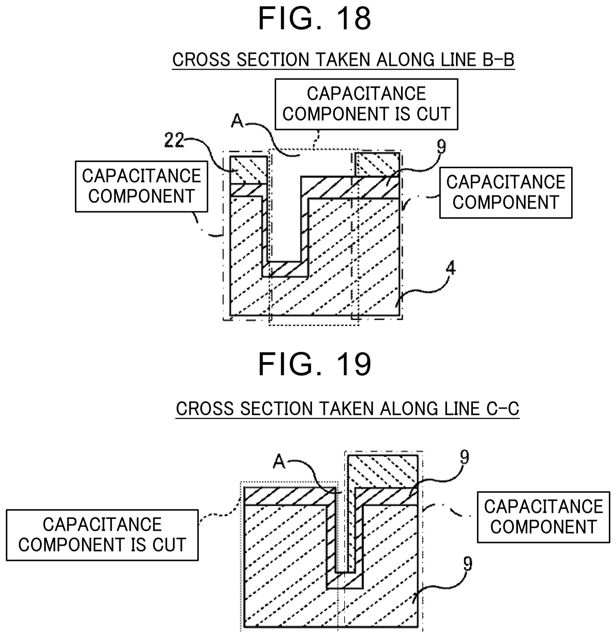

FIG. 17 shows details of the wiring structure 100B and shows the arrangement of the light emitting units 1, the wiring unit 2, and the emission portions 6. The light emitting units 1 are regularly arranged around the structure of the mesas 7, and the wiring unit 2 connecting the light emitting units 1 is shown. Cross sections taken along line B-B and line C-C shown in FIG. 17 are shown in FIGS. 18 and 19.

The cross section taken along line B-B shown by a dash-dotted line in FIG. 18 shows the structures of the wiring unit 2 and the light emitting unit 1 positioned below the wiring unit 2. Although the wiring unit 2 is provided above the semiconductor layer 4 via an insulating film 9, a region A where a part of the wiring unit 2 is not formed is present since the plurality of second wirings 22 are arranged to be spaced apart from each other in the second direction D2. For this reason, a capacitance component generated between the semiconductor layer 4 and the second wiring 22 is cut in this region A. Accordingly, it is possible to prevent an increase in unnecessary parasitic capacitance and to improve electrical characteristics.

Since a region A where a part of the second wiring 22 is not formed is also present in the cross section taken along line C-C shown by a dash-dotted line in FIG. 19 likewise, a capacitance component generated in the semiconductor layer 4 of the light emitting unit 1 is cut. It is possible to perform a more stable light emitting operation while reducing the wiring resistance, by devising a wiring shape as described above.

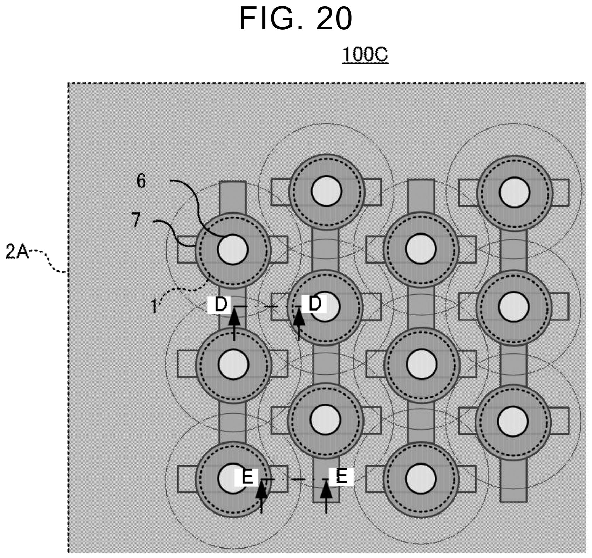

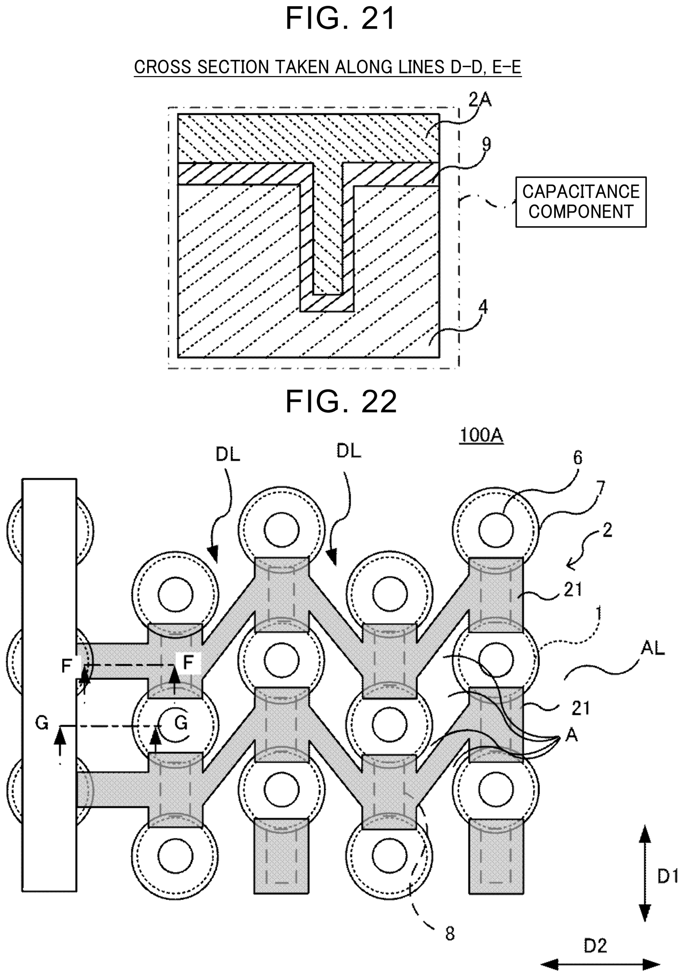

FIG. 21 shows a cross section of the wiring structure 100C according to the comparative example taken along line D-D and line E-E shown by dash-dotted lines in FIG. 20. Since the entire surface of the insulating film 9 is covered with the wiring unit 2A in a cross-sectional view shown in FIG. 21, a parasitic capacitance component is present in the second wiring 22 and the semiconductor layer 4. For this reason, in the wiring structure 100C, increased parasitic capacitance causes the falling time of a pulse signal to be lengthened.

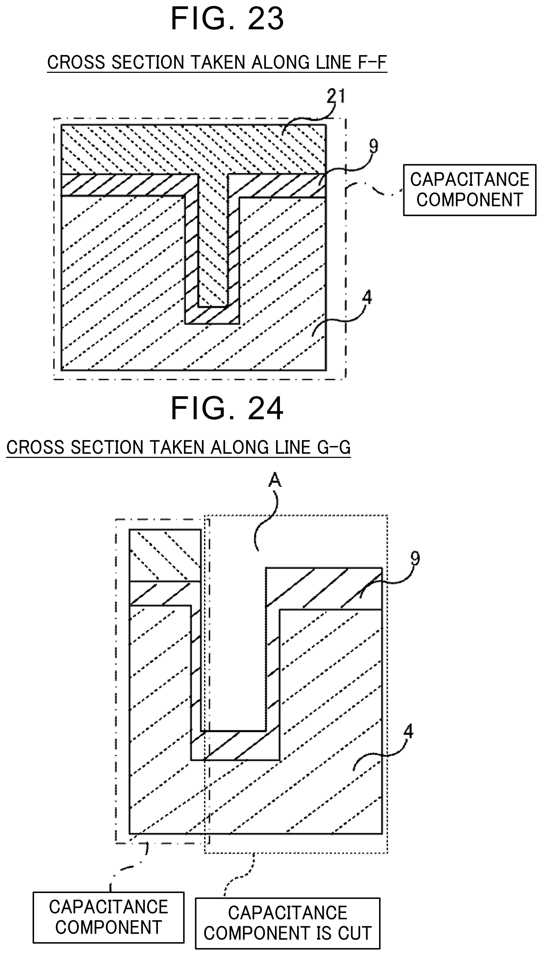

FIG. 22 shows details of the wiring structure 100A of the present disclosure, and FIGS. 23 and 24 show cross sections taken along line F-F and line G-G shown by dash-dotted lines in FIG. 22.

Since the entire upper portion of the insulating film 9 is covered with the first wiring 21 in FIG. 23, a parasitic capacitance component is present throughout the first wiring 21 and the semiconductor layer 4 positioned below the first wiring 21.

Since a region A where a part of the first wiring 21 is not formed is present in FIG. 24, a capacitance component generated in the semiconductor layer 4 of the light emitting unit 1 is cut. For this reason, a capacitance component generated between the semiconductor layer 4 and the first wiring 21 is cut in this region A. Accordingly, it is possible to prevent an increase in unnecessary parasitic capacitance and to improve electrical characteristics. In a case where this cross-sectional structure is used, it is possible to improve the response time of a pulse waveform and to improve the uniformity of a current.

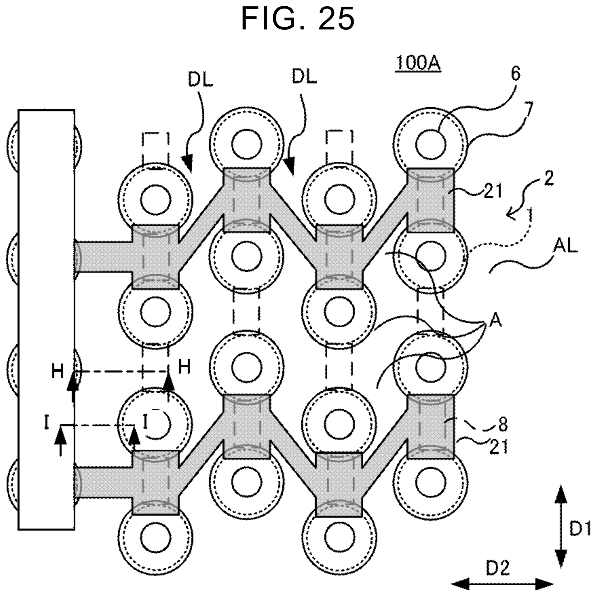

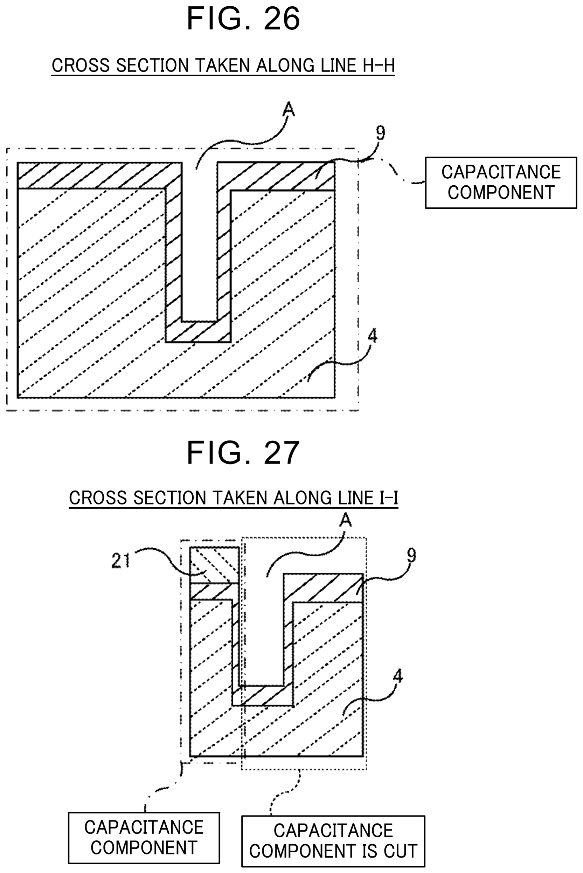

In a wiring structure 100A shown in FIG. 25, the number of first wirings 21 is reduced as compared with the wiring structure 100A shown in FIG. 22. FIGS. 26 and 27 show cross sections taken along line H-H and line I-I shown by dash-dotted lines in FIG. 25. Since the entire upper portion of the insulating film 9 is covered with the first wiring 21 in the cross section of the wiring structure 100A shown in FIG. 23 as described above, a parasitic capacitance component is present throughout the first wiring 21 and the semiconductor layer 4 positioned below the first wiring 21. On the other hand, since the number of first wirings 21 is reduced in the cross section of the wiring structure 100A shown in FIG. 26, the semiconductor layer 4 is not covered with the first wiring 21 and a capacitance component is cut. Accordingly, it is possible to prevent an increase in unnecessary parasitic capacitance and to improve electrical characteristics. Since a region A where a part of the first wiring 21 is not formed is present in the cross section shown in FIG. 27 as in the cross section shown in FIG. 24, a capacitance component generated in the semiconductor layer 4 of the light emitting unit 1 is cut.

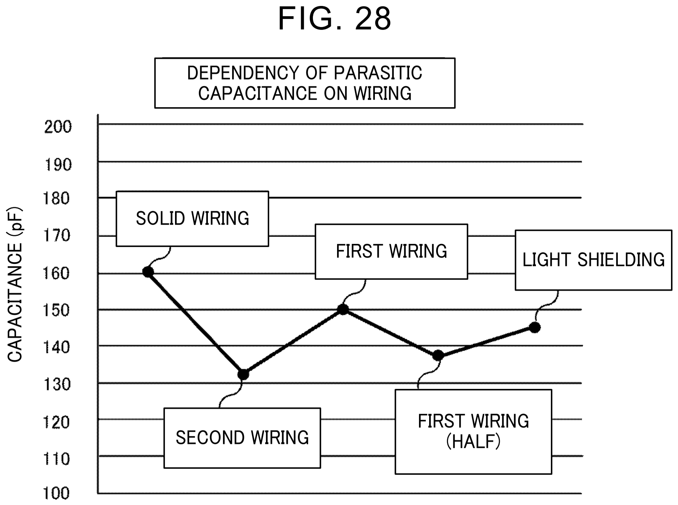

FIG. 28 shows a graph showing the dependency of parasitic capacitance on the wiring. A vertical axis represents capacitance and a horizontal axis represents different wiring structures. A "solid wiring" has the highest parasitic capacitance, which reaches about 160 pF. The reason for this is that the wiring covers the light emitting region widely and large parasitic capacitance is formed between the wiring and the semiconductor layer via the insulating film 9. The parasitic capacitance of the "second wiring" is lower than the parasitic capacitance of the solid wiring, and is about 130 pF. In a case where the coverage of the wiring is reduced, the parasitic capacitance is also reduced. The "first wiring" is, for example, a case of the wiring structure 100A shown in FIG. 2, and the parasitic capacitance of the "first wiring" is slightly larger than the parasitic capacitance of the second wiring 22 and is about 150 pF. This is considered to be due to the influence of the shape and distribution of the wiring. The "first wiring (half)" is, for example, a case of the wiring structure 100A shown in FIG. 15, and the parasitic capacitance of the "first wiring (half)" is lower than the parasitic capacitance of the "first wiring" and is about 140 pF. It can be seen that the parasitic capacitance is reduced in a case where the area of the wiring is further reduced. "Light shielding" corresponds to a case where a light shielding structure to be described later is provided. In this case, the light shielding acts as a dielectric, so that the parasitic capacitance slightly increases again (to about 150 pF).

As described above, the parasitic capacitance of the solid wiring is the largest, and the capacitance can be reduced in a case where wirings are subdivided and optimized as with the first wirings 21 and the second wirings 22 of the present disclosure. In particular, the parasitic capacitance of the second wiring 22 is the lowest, and the improvement of the electrical characteristics can be expected.

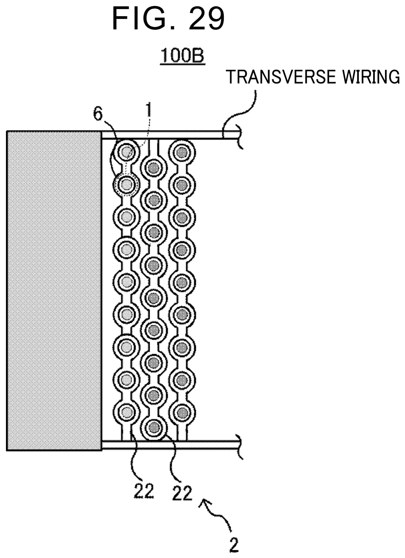

Here, a current distribution and resistance characteristics depending on differences in the wiring structures will be described with reference to FIGS. 29 to 32.

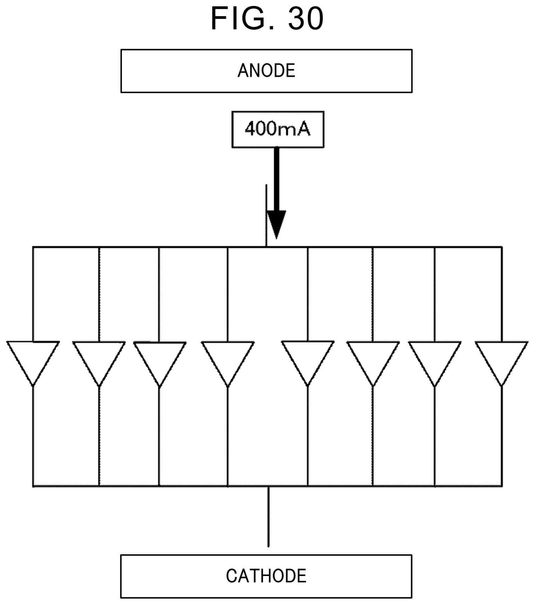

FIG. 29 shows a wiring structure 100B, in which, for example, eight light emitting units 1 are connected to one current path in series in one row. FIG. 30 schematically shows the current path in the wiring structure 100B shown in FIG. 29. An anode is a positive electrode side to which a current is supplied, and a cathode is a negative electrode side from which a current flows out. In the structure shown in FIG. 29, the light emitting units 1 are connected in series in the vertical direction, and a current of, for example, 400 mA flows through all the light emitting points via one wiring. In this case, since the current flows through one route, the resistance of the wiring increases, and a voltage drop is likely to occur in a case where a large current flows.

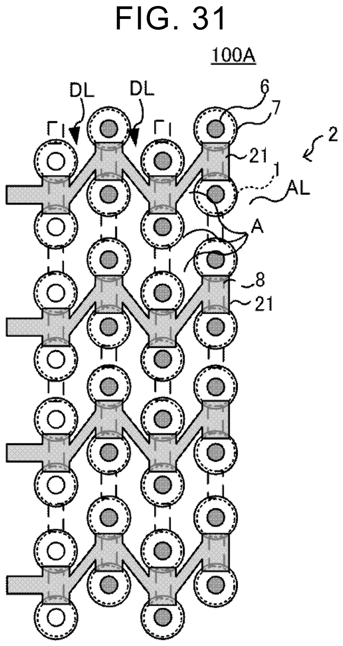

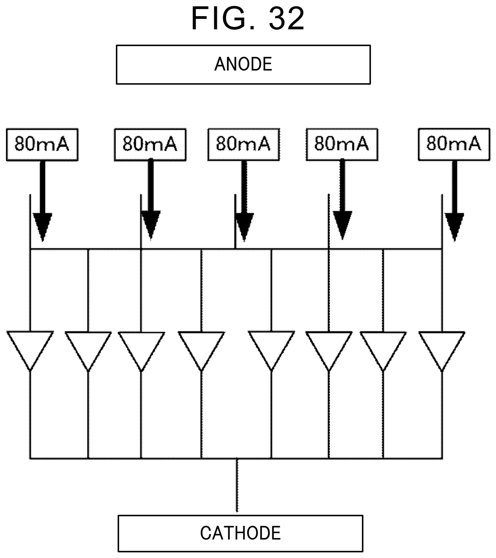

FIG. 31 shows a wiring structure 100A and, for example, five first wirings 21 are used here. FIG. 32 schematically shows a current path in the wiring structure 100A shown in FIG. 31. A current of 80 mA is supplied from the anode to each of the light emitting units 1. That is, since an identical current flows through each light emitting unit 1, the current balance of the entire wiring structure is uniform and the wiring resistance can be reduced. Stable light output in which light emission unevenness is suppressed can be realized in a case where the current balance is uniform.

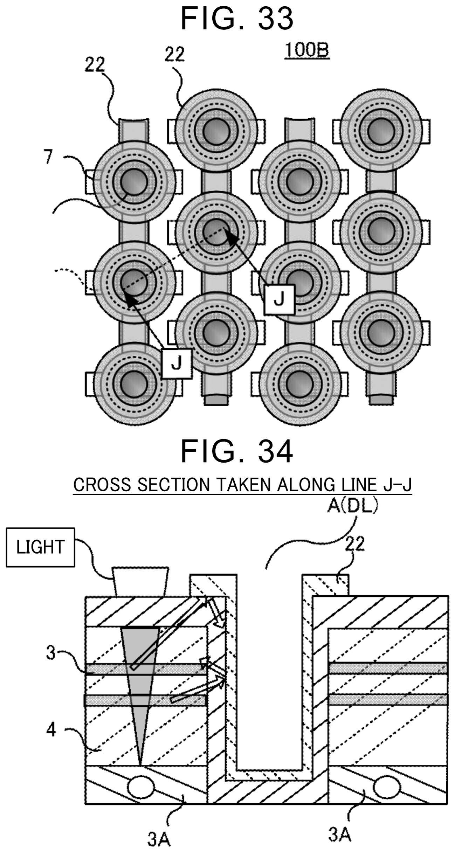

FIG. 33 shows details of a wiring structure 100B, and FIG. 34 shows a cross section taken along line J-J shown by a dash-dotted line in FIG. 33. In a case where light emitted from the adjacent light emitting unit 1 is unintentionally absorbed in a thyristor structure, an unnecessary current flows in the thyristor structure, which causes erroneous lighting. As shown in FIG. 34, a part of the second wirings 22 is provided in a space between the semiconductor layers 4 of two light emitting units 1 adjacent to each other. The reason for this is that the second wirings 22 cover only the peripheries of the semiconductor layers 4 in the wiring structure 100B. Since a part of the second wirings 22 serves as a light shielding structure, the light shielding structure prevents the diffusion of light emitted from the one thyristor 3 and suppresses the absorption of unnecessary light into adjacent thyristors 3. Accordingly, the unnecessary current flowing through the adjacent thyristors 3 is suppressed by the adjacent thyristors 3, so that erroneous lighting can be prevented and a stable light emitting operation can be realized.

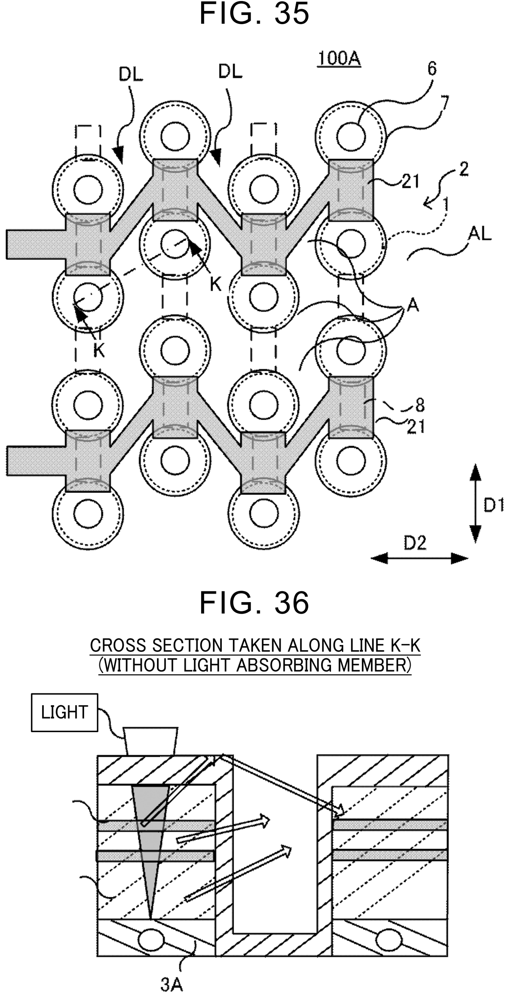

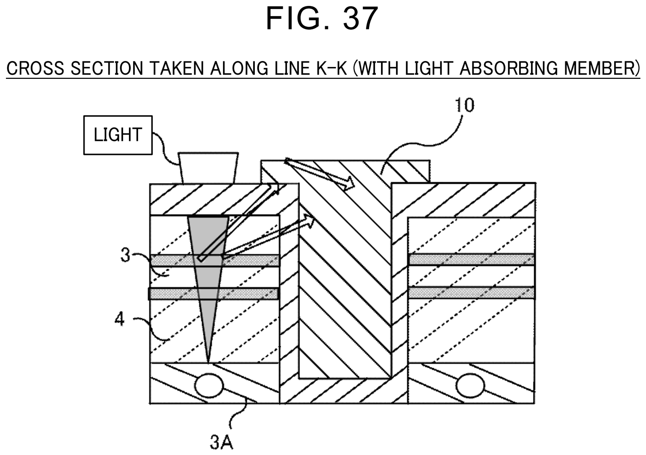

FIG. 35 shows details of the wiring structure 100A, and FIGS. 36 and 37 show a cross section taken along line K-K shown by a dash-dotted line in FIG. 35. In a case where the coverage is reduced in the wiring structure 100A, the semiconductor layer 4 is likely to absorb light, which causes erroneous lighting. Specifically, in a case where a light absorbing member 10 is not applied to the wiring structure 100A as shown in FIG. 36, light emitted from the light emitting point is likely to be diffused to the periphery. A part of the light may affect the surrounding thyristors 3 and other light emitting regions, which may cause erroneous lighting.

FIG. 37 shows the propagation of light in a case where the light absorbing member 10 is applied between adjacent light emitting units 1. As shown in FIG. 37, the wiring structure 100A may further include the photosensitive light absorbing member 10 provided in the region A. For example, the light absorbing member 10 is formed only in a region A (groove portion) between adjacent light emitting units 1 by the patterning of photosensitive polyimide, a photosensitive black resist, or the like. Since the light absorbing member 10 is provided, the light absorbing member 10 can suppress the diffusion of light and minimize the influence of light on unnecessary portions. Accordingly, it is possible to maintain a reduction in the capacitance of the wiring while preventing erroneous lighting.

In the wiring structure 100B shown in FIG. 3 and the like, the second wirings 22 adjacent to each other in the second direction D2 among the plurality of second wirings 22 may surround the peripheries of the emission portions 6 and shield the divided regions DL from the emission portions 6 while extending in the first direction D1. Accordingly, unnecessary electromagnetic interference can be suppressed as compared with a configuration in which all the emission portions 6 are not surrounded.

Further, the following supplementary notes will be disclosed with respect to the above-described exemplary embodiments.

### (Supplementary Note)

(((1))) A wiring structure comprising:
   a plurality of light emitting units that each include a thyristor structure and emit light at timings different from each other as signals are supplied to thyristors; and
   a wiring unit that connects electrodes, which supply a common current to the plurality of light emitting units, and the plurality of light emitting units to supply a current, and covers a region, which excludes at least a part of portions between emission portions through which light is emitted from the plurality of light emitting units and the plurality of light emitting units, while connecting the plurality of light emitting units emitting light at the different timings.
(((2))) The wiring structure according to (((1))), further comprising:
   one or more bridges that connect adjacent mesas forming the light emitting units and extend in a first direction; and
   a plurality of divided regions that are arranged to be spaced apart from each other in a second direction intersecting the first direction while extending in the first direction,
   wherein the wiring unit includes one or more first wirings that are arranged to be spaced apart from each other in the first direction while each extending in the second direction across the plurality of divided regions.
(((3))) The wiring structure according to (((2))),
   wherein the first wirings are provided on the bridges.
(((4))) The wiring structure according to (((2))),
   wherein the first wirings are provided across some of the plurality of bridges.
(((5))) The wiring structure according to (((3))) or (((4))),
   wherein the mesas adjacent to each other in the second direction are arranged to be offset from each other in the first direction, and
   the first wirings are formed in a meandering shape or a zigzag shape in plan view.
(((6))) The wiring structure according to (((1))), further comprising:
   one or more bridges that connect adjacent mesas forming the light emitting units and extend in a first direction; and
   a plurality of divided regions that are arranged to be spaced apart from each other in a second direction intersecting the first direction while extending in the first direction,
   wherein the wiring unit includes one or more second wirings that are arranged to be spaced apart from each other in the second direction while each covering a part of the mesas and extending in the first direction.
(((7))) The wiring structure according to (((6))),
   wherein the second wirings do not cross the plurality of divided regions.
(((8))) The wiring structure according to (((6))),
   wherein the second wirings adjacent to each other in the second direction among the plurality of second wirings are connected to each other at one or a plurality of positions in the first direction.
(((9))) The wiring structure according to (((1))),
   wherein the wiring unit covers a region between a plurality of electrodes arranged to be spaced apart from each other with the plurality of light emitting units interposed therebetween while connecting the plurality of electrodes.
(((10))) The wiring structure according to (((1))),
   wherein each of the light emitting units consists of a thyristor having a PNPN junction and a vertical-cavity surface-emitting laser having a PN junction different from the junction of the thyristor, and
   the thyristor is formed on a wiring side, and further includes a dielectric that is provided between the wiring unit and a semiconductor layer included in the thyristor structure and is made of a low-dielectric-constant material.
(((11))) The wiring structure according to (((6))),
   wherein the second wirings adjacent to each other in the second direction among the plurality of second wirings surround peripheries of the emission portions and shield the divided regions from the emission portions while extending in the first direction.
(((12))) The wiring structure according to (((2))), further comprising:
   a photosensitive light absorbing member that is provided in each of the divided regions.
(((13))) A light emitting device comprising:
   the wiring structure according to any one of (((1))) to (((12))); and
   the plurality of electrodes.

According to (((1))), since the wirings are provided only in the region A excluding a part of portions between the emission portions and the light emitting units, it is possible to reduce parasitic capacitance due to the wirings around the light emitting units while suppressing an increase in wiring resistance. For this reason, the falling time of a pulse waveform of a VCSEL device due to the parasitic capacitance is shortened, so that the risk of erroneous lighting can be reduced.

According to (((2))), it is possible to uniformly supply a current.

According to (((3))), it is possible to achieve the uniformity of current supply.

According to (((4))), it is possible to further suppress an increase in parasitic capacitance.

According to (((5))), since the mesas are offset from each other in the first direction and the second direction, it is possible to achieve a reduction in size and to suppress an increase in parasitic capacitance.

According to (((6))), it is possible to reduce parasitic capacitance while suppressing the influence of the light emission of the other light emitting unit groups and the external light.

According to (((7))), since wiring does not have to be performed on a portion where there is a difference in height, that is, a portion corresponding to a high mesa and a portion corresponding to a low divided region, it is difficult to form a film in a case where there is a difference in height, but it is easy to perform wiring on a portion where there is no difference in height.

According to (((8))), the uniformity of current supply is improved.

According to (((9))), the current is more stable than in a case where one electrode is provided.

According to (((10))), parasitic capacitance is reduced as compared with a case where the dielectric is provided without focusing on a dielectric constant.

According to (((11))), it is possible to suppress unnecessary electromagnetic interference as compared with a configuration in which all the emission portions are not surrounded.

According to (((12))), since the photosensitive light absorbing member is provided in the divided region, it is possible to reduce the influence of external light to prevent the malfunction of the light emitting unit.

According to (((13))), the falling time of the VCSEL of the light emitting device is shortened and a short-pulse response is enabled.

The foregoing description of the exemplary embodiments of the present invention has been provided for the purposes of illustration and description. It is not intended to be exhaustive or to limit the invention to the precise forms disclosed. Obviously, many modifications and variations will be apparent to practitioners skilled in the art. The embodiments were chosen and described in order to best explain the principles of the invention and its practical applications, thereby enabling others skilled in the art to understand the invention for various embodiments and with the various modifications as are suited to the particular use contemplated. It is intended that the scope of the invention be defined by the following claims and their equivalents.

### Brief Description of the Reference Symbols

1: light emitting unit
2: wiring unit
2A: wiring unit
3: thyristor
3A: VCSEL
4: semiconductor layer
5: electrode
6: emission portion
7: mesa
8: bridge
9: insulating film
10: light absorbing member
21: first wiring
22: second wiring
100A: wiring structure
100B: wiring structure
100C: wiring structure
200: light emitting device
A: region
AL: region
DL: divided region
D1: first direction
D2: second direction

## Claims

1. A wiring structure comprising:
a plurality of light emitting units that each include a thyristor structure and emit light at timings different from each other as signals are supplied to thyristors; and
a wiring unit that connects electrodes, which supply a common current to the plurality of light emitting units, and the plurality of light emitting units to supply a current, and covers a region, which excludes at least a part of portions between emission portions through which light is emitted from the plurality of light emitting units and the plurality of light emitting units, while connecting the plurality of light emitting units emitting light at the different timings.

2. The wiring structure according to claim 1, further comprising:
one or more bridges that connect adjacent mesas forming the light emitting units and extend in a first direction; and
a plurality of divided regions that are arranged to be spaced apart from each other in a second direction intersecting the first direction while extending in the first direction,
wherein the wiring unit includes one or more first wirings that are arranged to be spaced apart from each other in the first direction while each extending in the second direction across the plurality of divided regions.

3. The wiring structure according to claim 2,
wherein the first wirings are provided on the bridges.

4. The wiring structure according to claim 2,
wherein the first wirings are provided across some of the plurality of bridges.

5. The wiring structure according to claim 3 or 4,
wherein the mesas adjacent to each other in the second direction are arranged to be offset from each other in the first direction, and
the first wirings are formed in a meandering shape or a zigzag shape in plan view.

6. The wiring structure according to claim 1, further comprising:
one or more bridges that connect adjacent mesas forming the light emitting units and extend in a first direction; and
a plurality of divided regions that are arranged to be spaced apart from each other in a second direction intersecting the first direction while extending in the first direction,
wherein the wiring unit includes one or more second wirings that are arranged to be spaced apart from each other in the second direction while each covering a part of the mesas and extending in the first direction.

7. The wiring structure according to claim 6,
wherein the second wirings do not cross the plurality of divided regions.

8. The wiring structure according to claim 6,
wherein the second wirings adjacent to each other in the second direction among the plurality of second wirings are connected to each other at one or a plurality of positions in the first direction.

9. The wiring structure according to claim 1,
wherein the wiring unit covers a region between a plurality of electrodes arranged to be spaced apart from each other with the plurality of light emitting units interposed therebetween while connecting the plurality of electrodes.

10. The wiring structure according to claim 1,
wherein each of the light emitting units consists of a thyristor having a PNPN junction and a vertical-cavity surface-emitting laser having a PN junction different from the junction of the thyristor, and
the thyristor is formed on a wiring side, and further includes a dielectric that is provided between the wiring unit and a semiconductor layer included in the thyristor structure and is made of a low-dielectric-constant material.

11. The wiring structure according to claim 6,
wherein the second wirings adjacent to each other in the second direction among the plurality of second wirings surround peripheries of the emission portions and shield the divided regions from the emission portions while extending in the first direction.

12. The wiring structure according to claim 2, further comprising:
a photosensitive light absorbing member that is provided in each of the divided regions.

13. A light emitting device comprising:
the wiring structure according to any one of claims 1 to 12; and
the plurality of electrodes.
